# EUROPEAN PATENT APPLICATION

(11) **EP 4 629 395 A1**
(43) Date of publication of application: **08.10.2025**
(21) Application number: 23907632.6
(22) Date of filing: 15.12.2023
(51) Int. Cl.: H01M 10/42, H01M 10/48, G06N 3/08, G06N 20/00, G01R 31/367

(54) **BATTERY STATE PREDICTION DEVICE AND OPERATION METHOD THEREFOR**

(30) Priority: 19.12.2022 KR 20220178733; 13.12.2023 KR 20230180528
(71) Applicant: LG Energy Solution, Ltd., Seoul 07335 (KR)
(72) Inventor: CHUN, Joo Young, Daejeon 34122 (KR)
(74) Representative: Plasseraud IP
(86) International application number: PCT/KR2023/020817
(87) International publication number: WO 2024/136347

(57) **Abstract**

A battery state prediction apparatus according to an embodiment disclosed herein includes a generation unit configured to generate a plurality of machine learning models trained based on battery data and features included in the battery data to predict a gas generation amount of a battery and a controller configured to obtain a plurality of pieces of prediction data for predicting the gas generation amount of the battery by applying the battery data to the plurality of machine learning models and predict the gas generation amount of the battery based on the plurality of pieces of prediction data.

## Description

### [TECHNICAL FIELD]

### CROSS-REFERENCE TO RELATED APPLICATIONS

This application claims priority to and the benefit of Korean Patent Application No. 10-2022-0178733 filed in the Korean Intellectual Property Office on December 19, 2022, and Korean Patent Application No. 10-2023-0180528 filed in the Korean Intellectual Property Office on December 13, 2023, the entire contents of which are incorporated herein by reference.

### TECHNICAL FIELD

Embodiments disclosed herein relate to a battery state prediction apparatus and an operating method thereof.

### [BACKGROUND ART]

An electric vehicle is supplied with electricity from outside to charge a battery, and then a motor is driven by a voltage charged in the battery to obtain power. The battery of the electric vehicle may have heat generated therein by chemical reaction occurring in a process of charging and discharging electricity, and the heat may impair performance and lifetime of the battery, resulting in a phenomenon where an internal gas of the battery is generated.

A gas generated inside the battery may act as a resistance or may be a cause for deformation of a battery module and a battery pack, increasing a product defect rate. Thus, a battery management system (BMS) that monitors temperature, voltage, and current of the battery is driven to predict whether a gas is generated inside the battery and a gas generation amount.

The battery management system may predict a gas generation amount of the battery by training battery data in an artificial intelligence model that analyzes the state of the battery. However, when the same battery data is input to an artificial intelligence model as input data Input, the battery management apparatus may derive the same output data Output at all times, failing to reflect an actual distribution in which the battery actually generates a distribution of different gas generation amounts in the same environment.

### [DISCLOSURE]

### [TECHNICAL PROBLEM]

Embodiments disclosed herein aim to provide a battery state prediction apparatus and an operating method thereof in which gas generation amount prediction data in a probability distribution form may be obtained by using a plurality of artificial intelligence models for predicting a battery gas generation amount.

Technical problems of the embodiments disclosed herein are not limited to the above-described technical problems, and other unmentioned technical problems would be clearly understood by one of ordinary skill in the art from the following description.

### [TECHNICAL SOLUTION]

A battery state prediction apparatus according to an embodiment disclosed herein includes a generation unit configured to generate a plurality of machine learning models trained based on battery data and features included in the battery data to predict a gas generation amount of a battery and a controller configured to obtain a plurality of pieces of prediction data for predicting the gas generation amount of the battery by applying the battery data to the plurality of machine learning models and predict the gas generation amount of the battery based on the plurality of pieces of prediction data.

According to an embodiment, the plurality of machine learning models may include a plurality of deep neural network (DNN) models, and the controller may be further configured to obtain the plurality of pieces of prediction data by applying the battery data to the plurality of DNN models.

According to an embodiment, the battery data may include a temperature, a state of charge (SOC), and a state of health (SOH) of the battery, which are accumulatively measured, and the features of the battery data may include at least one or more of an electrode type, an assembly process, and a separator type of the battery.

According to an embodiment, the controller may be further configured to apply a weight to each of the plurality of pieces of prediction data based on a weight applied based on the features of the battery data in a process of training the DNN model that generates each of the plurality of pieces of prediction data, and input the plurality of pieces of prediction data to which the weight is applied to an ensemble learning model to generate prediction data for the gas generation amount in a probability distribution form.

According to an embodiment, the controller may be further configured to calculate a mean of the prediction data for the gas generation amount in the probability distribution form, and determine accuracy of the plurality of machine learning models by comparing the mean with a pre-stored gas generation amount measurement value of the battery.

An operating method of a battery state prediction apparatus according to an embodiment disclosed herein includes generating a plurality of machine learning models trained based on battery data and features included in the battery data to predict a gas generation amount of a battery, obtaining a plurality of pieces of prediction data for predicting the gas generation amount of the battery by applying the battery data to the plurality of machine learning models, and predicting the gas generation amount of the battery based on the plurality of pieces of prediction data.

According to an embodiment, the plurality of machine learning models may include a plurality of deep neural network (DNN) models, and the obtaining of the plurality of pieces of prediction data for predicting the gas generation amount of the battery by applying the battery data to the plurality of machine learning models may include obtaining the plurality of pieces of prediction data by applying the battery data to the plurality of DNN models.

According to an embodiment, the generating of the plurality of machine learning models that predict the gas generation amount of the battery based on the battery data may include generating the plurality of machine learning models based on the battery data including a temperature, a state of charge (SOC), and a state of health (SOH) of the battery, which are accumulatively measured, and the features of the battery data may include at least one or more of an electrode type, an assembly process, and a separator type of the battery.

According to an embodiment, the predicting of the gas generation amount of the battery based on the plurality of pieces of prediction data may include applying a weight to each of the plurality of pieces of prediction data based on a weight applied based on the features of the battery data in a process of training the DNN model that generates each of the plurality of pieces of prediction data and inputting the plurality of pieces of prediction data to which the weight is applied to an ensemble learning model to generate prediction data for the gas generation amount in a probability distribution form.

According to an embodiment, the predicting of the gas generation amount of the battery based on the plurality of pieces of prediction data may include calculating a mean of the prediction data for the gas generation amount in the probability distribution form and determining accuracy of the plurality of machine learning models by comparing the mean with a pre-stored gas generation amount measurement value of the battery.

### [ADVANTAGEOUS EFFECTS]

A battery state prediction apparatus and an operating method thereof according to an embodiment disclosed herein may obtain gas generation amount prediction data in a probability distribution form by using a plurality of artificial intelligence models.

### [DESCRIPTION OF DRAWINGS]

FIG. 1 illustrates a battery pack according to an embodiment disclosed herein.
FIG. 2 is a view for generally describing a battery state prediction apparatus according to an embodiment disclosed herein.
FIG. 3 is a block diagram showing a configuration of a battery state prediction apparatus, according to an embodiment disclosed herein.
FIG. 4 is a view for describing an operation of a generation unit, according to an embodiment disclosed herein.
FIG. 5 is a view for describing an operating method of a controller, according to an embodiment disclosed herein.
FIG. 6 is a flowchart of an operating method of a battery state prediction apparatus according to an embodiment disclosed herein.
FIG. 7 is a block diagram showing a hardware configuration of a computing system for implementing a battery state prediction apparatus according to an embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

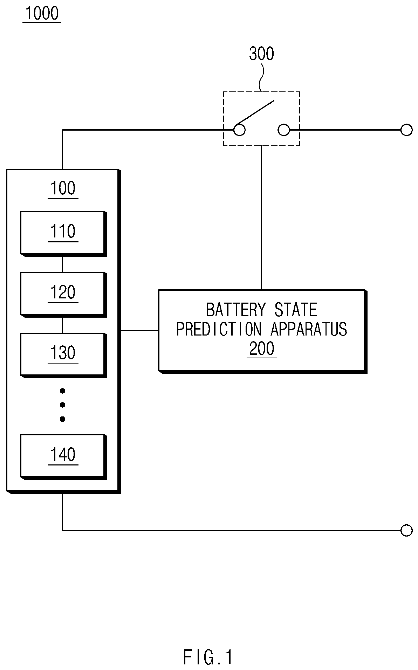

FIG. 1 illustrates a battery pack according to an embodiment disclosed herein.

Referring to FIG. 1, a battery pack 1000 according to an embodiment disclosed herein may include a battery module 100, a battery state prediction apparatus 200, and a relay 300.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, a Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery state prediction apparatus 200 may predict a gas generation amount of the plurality of battery cells 110, 120, 130, and 140 based on temperature, current, voltage, state of charge (SOC), and state of health (SOH) data of the plurality of battery cells 110, 120, 130, and 140. The battery state prediction apparatus 200 may predict a gas generation amount of the plurality of battery cells 110, 120, 130, and 140 based on battery data A of the plurality of battery cells 110, 120, 130, and 140.

According to an embodiment, the battery state prediction apparatus 200 may be implemented in the form of a battery management system (BMS). Moreover, according to an embodiment, the battery state prediction apparatus 200 may be mounted on a battery management system.

Herein, the battery management system may manage and/or control a state and/or an operation of the battery module 100. For example, the battery management system may manage and/or control the states and/or operations of the plurality of battery cells 110, 120, 130, and 140 included in the battery module 100. The battery management system may manage charge and/or discharge of the battery module 100.

In addition, the battery management system may monitor voltage, current, temperature, etc., of the battery module 100 and/or each of the plurality of battery cells 110, 120, 130, and 140 included in the battery module 100. A sensor or various measurement modules for monitoring performed by the battery management system, which are not shown, may be additionally installed in the battery module 100, a charging/discharging path, any position of the battery module 100, etc. The battery management apparatus may calculate a parameter indicating a state of the battery module 100, e.g., an SOC or SOH, etc., based on a measurement value such as monitored voltage, current, temperature, etc.

The battery management system may control an operation of the relay 300. For example, the battery management system may short-circuit the relay 300 to supply power to the target device. The battery management system may short-circuit the relay 300 when a charging device is connected to the battery pack 1000.

The battery management system may calculate a cell balancing time of each of the plurality of battery cells 110, 120, 130, and 140. Herein, the cell balancing time may be defined as a time required for balancing of the battery cell. For example, the battery management apparatus may calculate a cell balancing time based on an SOC, a battery capacity, and a balancing efficiency of each of the plurality of battery cells 110, 120, 130, and 140.

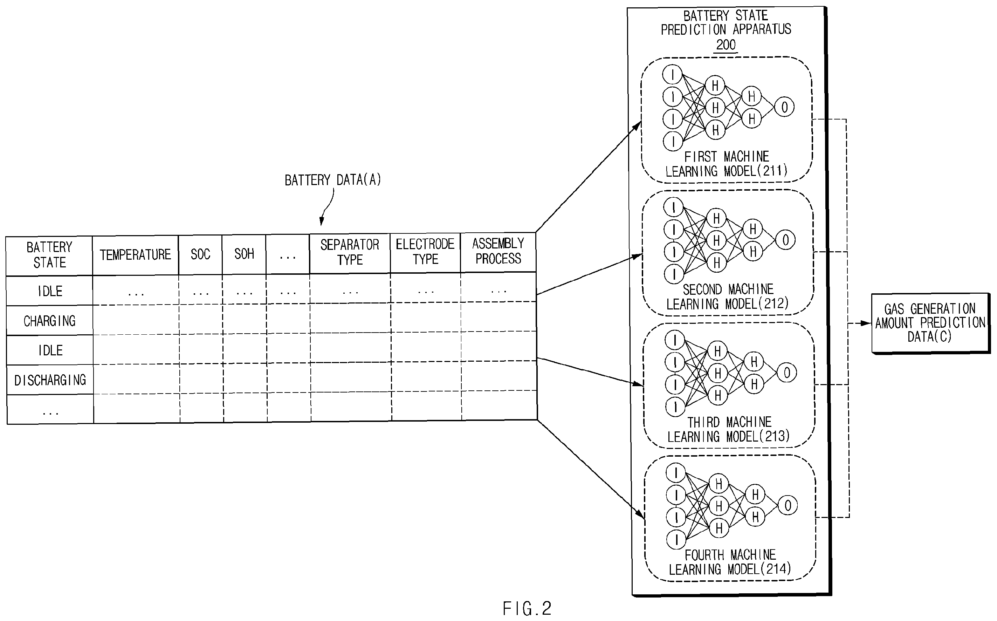

FIG. 2 is a view for generally describing a battery state prediction apparatus according to an embodiment disclosed herein.

Referring to FIG. 2, the battery state prediction apparatus 200 may extract a part of the battery data A and input the same to a plurality of machine learning models 211, 212, 213, and 214.

Although the plurality of machine learning models are illustrated as four in FIG. 2, the present disclosure is not limited thereto, and the plurality of machine learning models 211, 212, 213, and 214 may include n machine learning models (n is a natural number equal to or greater than 2).

The battery state prediction apparatus 200 may obtain the battery data A of the plurality of battery cells 110, 120, 130, and 140. To identify a gas generation amount of the plurality of battery cells 110, 120, 130, and 140, the battery management system may obtain the battery data A including a measurement value of a battery from a voltage value at which the SOC of the battery is 0% up to a voltage value at which the SOC of the battery is 100%. Thus, the battery state prediction apparatus 200 may obtain the battery data A including voltages, currents, temperatures, SOC, and SOH of the plurality of battery cells 110, 120, 130, and 140 accumulatively measured during a charging/discharging period.

Herein, the battery data A may further include at least one feature among features of the battery data A including a separator type, an assembling process, an electrode type, etc., of the battery. That is, the battery data A may further include at least one of data related to which type the separator type of the battery is, through which assembling process the battery is assembled, and/or which electrode type the battery has.

The battery state prediction apparatus 200 may predict a gas generation amount of the battery by inputting the battery data A to the plurality of machine learning models 211, 212, 213, and 214. Herein, machine learning refers to a technique for predicting a certain result by training a computer. Generally, a result of using machine learning includes a process of preparing train data for training a machine and training the computer in a manner suitable for a problem, a process of validating a model with test data, and a process of predicting a result with a model having passed the verification.

For machine learning, it is important that train data well represents a feature to be generalized through machine learning, and thus the train data is generated using train data limitedly selected according to certain criteria For a low relation between the feature to be generalized through machine learning and a feature of train data, a sampling noise may occur, and a pattern having a machine problem analysis model embedded therein is difficult to find, increasing an error of the model separately from the accuracy of the machine problem analysis model and thus degrading the reliability of the model. Thus, a machine learning technique requires investment of time in evaluating train data and processing data to select a training data set.

The battery state prediction apparatus 200 may extract at least a part of the battery data A and generate a train data set to generate and train the plurality of machine learning models 211, 212, 213, and 214. Herein, the plurality of machine learning models 211, 212, 213, and 214 may refer to learning models capable of predicting a state of the battery including the gas generation amount of the battery based on input battery data.

That is, the battery state prediction apparatus 200 may generate the plurality of machine learning models 211, 212, 213, and 214 of the same structure based on one training data set generated by extracting at least a part of the battery data A. The battery state prediction apparatus 200 may obtain prediction data for predicting a battery gas generation amount of each of the plurality of machine learning models 211, 212, 213, and 214 through the plurality of machine learning models 211, 212, 213, and 214 generated based on the one training data set generated by extracting at least a part of the battery data A.

The battery state prediction apparatus 200 may finally obtain single gas generation amount prediction data C in a probability distribution form by combining the prediction data for predicting the battery gas generation amount of each of the plurality of machine learning models 211, 212, 213, and 214. Thus, the battery state prediction apparatus 200 may obtain output data Output of each of the machine learning models 211, 212, 213, and 214 of the same structure based on single input data Input and combine each output data to finally obtain the single gas generation amount prediction data C in a probability distribution form, thereby reducing an error of learning and improving reliability.

The output data generated by an artificial intelligence model may include a random error and a main effect. When repeating a test several times based on single input data, the artificial intelligence model may obtain a random error or a white noise that is different output data. Herein, when the artificial intelligence model repeats the same test sufficiently many times, a mean of random errors may converge to 0 and the artificial intelligence model may merely obtain main effect data.

The battery state prediction apparatus 200 may obtain a plurality of pieces of output data at the same time by inputting the same input data to the plurality of machine learning models 211, 212, 213, and 214 to set up the same test environment, thereby obtaining an effect as if repeating the test. That is, the battery state prediction apparatus 200 may input at least a part of the same battery data A to the plurality of machine learning models 211, 212, 213, and 214 of the same structure, thereby predicting a battery gas generation amount with high accuracy corresponding to the main effect data.

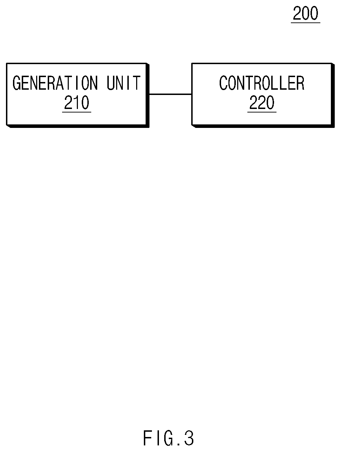

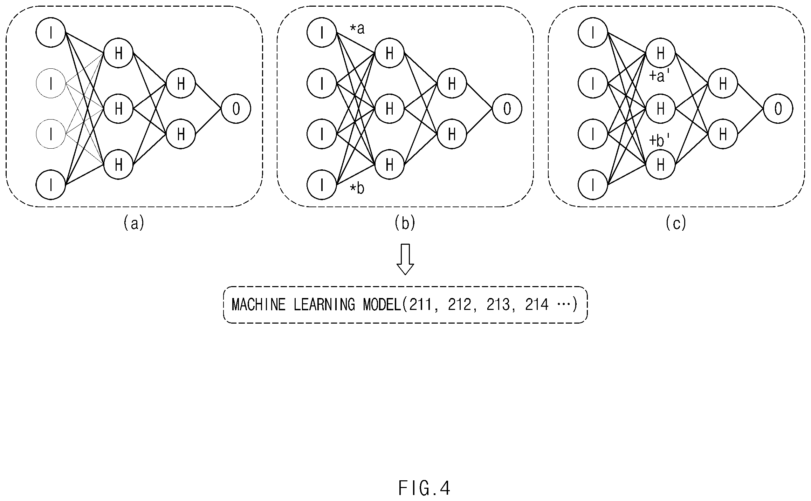

FIG. 3 is a block diagram showing a structure of a battery state prediction apparatus according to an embodiment disclosed herein, and FIG. 4 is a view for describing an operation of a generation unit according to an embodiment disclosed herein.

Hereinbelow, with reference to FIGS. 3 and 4, a configuration and an operation of the battery state prediction apparatus 200 will be described in detail.

Referring to FIG. 3, the battery state prediction apparatus 200 may include a generation unit 210 and a controller 220.

The generation unit 210 may collect the battery data A. For example, the battery data A may be defined as a value that records a battery state change from discharge states of the plurality of battery cells 110, 120, 130, and 140 to full charge states thereof or from the full charge states to the discharge states. For example, the battery data A may include voltage, current, temperature, SOC, and SOH of the battery, measured accumulatively. Herein, the SOH may include capacity degradation and resistance degradation of the battery. In addition, the battery data A may further include at least one of data related to which type the separator type of the battery is, through which assembling process the battery is assembled, and/or which electrode type the battery has.

The generation unit 210 may generate the plurality of machine learning models 211, 212, 213, and 214 by extracting at least a part of the battery data A as the training data set. For example, the generation unit 210 may generate the plurality of machine learning models 211, 212, 213, and 214 by extracting 80 % of the battery data A as the training data set.

According to an embodiment, the plurality of machine learning models 211, 212, 213, and 214 may include a plurality of deep neural network (DNN) models. The DNN model is an artificial neural network technique including multiple hidden layers between an input layer and an output layer. The DNN model may learn various complex nonlinear relationships by including the multiple hidden layers. The generation unit 210 may generate the plurality of machine learning models 211, 212, 213, and 214 capable of predicting a battery gas generation amount by using at least a part of the battery data A as the training data set. An internal gas generation amount of the battery may increase as SOC and temperature of the battery increase, and the internal gas generation amount of the battery may also differ with a type of a separator of the battery, an assembly process of the battery, and/or a type of an electrode of the battery. Thus, the plurality of machine learning models 211, 212, 213, and 214 may predict whether an internal gas of the battery is generated and a gas generation amount based on the voltage, the current, the temperature, the SOC, the SOH, the assembly process, the electrode type, and the separator type of the battery, included in the battery data A.

Referring to FIG. 4 ,the generation unit 210 may generate the plurality of machine learning models 211, 212, 213, and 214 trained based on at least one of features of the battery data A. For example, when the separator type and the electrode type among the features of the battery data A are considered, the generation unit 210 may extract the battery data A including the separator type and the electrode type of the battery, except for the voltage, the current, the temperature, the SOC, and the SOH of the battery, as the training data set of the battery A, thereby generating the plurality of machine learning models 211, 212, 213, and 214.

Herein, the generation unit 210 may train the plurality of machine learning models 211, 212, 213, and 214 with the battery data A by applying various weights to the features of the battery data A including the separator type, the assembly process, and the electrode type of the battery among various features included in the battery data A.

For example, the generation unit 210 may use a regularization scheme for resolving overfitting of the plurality of machine learning models 211, 212, 213, and 214 by minimizing intervention of relatively unimportant data among the separator type, the assembly process, and the electrode type of the battery based on a drop-out scheme (a), thereby generating the plurality of machine learning models 211, 212, 213, and 214. That is, the generation unit 210 may generate the plurality of machine learning models 211, 212, 213, and 214 by training the machine learning models 211, 212, 213, and 214 with the battery data A from which connection of a node related to a feature, intervention of which is unwanted or is to be minimized, among the separator type, the assembly process, and the electrode type of the battery, is removed.

In another example, the generation unit 210 may generate the plurality of machine learning models 211, 212, 213, and 214 trained with the battery data A by (b) fixing weights applied to the features of the battery data A including the separator type, the assembly process, and the electrode type of the battery among various features included in the battery data A. For example, to generate a machine learning model affected much by the separator type of the battery, the generation unit 210 may train the machine learning model with the battery data A by applying a high weight (e.g., *a) to the separator type among the features of the battery data A. To generate a machine learning model affected less by the electrode type of the battery, the generation unit 210 may train the machine learning model with the battery data A by applying a low weight (e.g., *b) to the electrode type among the features of the battery data A.

In another example, the generation unit 210 may generate the plurality of machine learning models 211, 212, 213, and 214 trained with the battery data A by (c) applying a bias (e.g., +a' or +b') to a node connected to the battery data A including the separator type, the assembly process, and the electrode type of the battery among various features included in the battery data A.

In addition, the generation unit 210 may generate the plurality of machine learning models 211, 212, 213, and 214 trained with the battery data A based on weight regulations including L1 regulation Lasso and L2 regulation Ridge, and an embodiment disclosed herein is not limited to this example.

The generation unit 210 may min-max scale at least a part of the battery data A, Herein, min-max scaling is a method of adjusting a range of all variables because when a size or unit of a numeric variable differs from variable to variable, an impact thereof on a dependent variable is not properly reflected. The generation unit 210 may convert at least a part of the battery data A into a value between 0 and 1 by min-max scaling the at least a part of the battery data A.

The generation unit 210 may determine accuracy of the plurality of machine learning models 211, 212, 213, and 214 by K-fold cross validation with respect to the plurality of machine learning models 211, 212, 213, and 214. K-fold cross validation is a method of dividing a pre-processed data set into a training data set and a test set and dividing the training data set into 'K' folds to use one fold for validation and (K-1) folds for model training, thereby using every data for training and validation processes. For example, the generation unit 210 may determine accuracy of the plurality of machine learning models 211, 212, 213, and 214 by 5-fold cross validation with respect to the plurality of machine learning models 211, 212, 213, and 214.

For example, the generation unit 210 may evaluate performance of the plurality of machine learning models 211, 212, 213, and 214 based on a mean absolute error (MAE) that is a mean of an absolute value into which an error between an actual value and a prediction value is converted.

The controller 220 may input at least a part of the battery data A including voltage, current, temperature, SOC, and SOH changes of the plurality of battery cells 110, 120, 130, and 140, as a test data set, into the plurality of machine learning models 211, 212, 213, and 214.

For example, after the generation unit 210 generates the plurality of machine learning models 211, 212, 213, and 214 by extracting 80 % of the battery data A as a training data set, the controller 220 may extract the other 20 % as a test data set and input the same to the plurality of machine learning models 211, 212, 213, and 214.

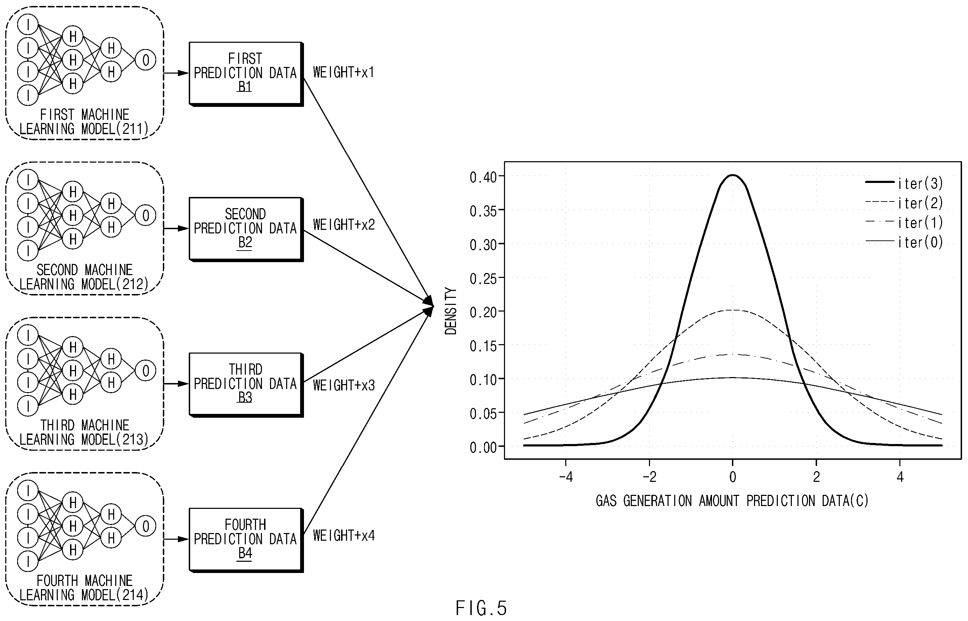

FIG. 5 is a view for describing an operating method of a controller, according to an embodiment disclosed herein.

Referring to FIG. 5, the controller 220 may apply at least a part of the battery data A to the plurality of machine learning models 211, 212, 213, and 214 to obtain a plurality of pieces of prediction data B1, B2, B3, and B4 for predicting battery gas generation amounts of the battery respectively from the plurality of machine learning models 211, 212, 213, and 214. That is, the controller 220 may obtain a plurality of pieces of output data Output by respectively inputting at least a part of the battery data A that is single input data Input to individual machine learning models. The controller 220 may generate the gas generation amount prediction data C for predicting the gas generation amount of the battery, based on the plurality of pieces of prediction data B1, B2, B3, and B4.

The controller 220 may predict the state of the battery, based on the plurality of pieces of prediction data B1, B2, B3, and B4. According to an embodiment, the controller 220 may apply weights x1, x2, x3, and x4 respectively to the plurality pieces of prediction data B1, B2, B3, and B4 generated by the plurality of machine learning models 211, 212, 213, and 214 based on at least one or more of the separator type, the assembly process, and the electrode type of the battery among the features of the battery data A. For example, when the weight x1 is applied to first prediction data B1 based on any one of the features of the battery data A, the size of the first prediction data B1 may be amplified to increase a rate of the first prediction data B1 with respect to the entire prediction data B1, B2, B3, and B4. Herein, the weights x1, x2, x3, and x4 respectively applied to the plurality of pieces of prediction data B1 B2, B3, and B4 may be related to the weight applied to the feature of the battery data A in training of each of the plurality of machine learning models 211, 212, 213, and 214.

The controller 220 may apply weights to the plurality of pieces of prediction data B1, B2, B3, and B4 according to the weight applied based on the feature of the battery data A in a process of training an DNN model used in generation of the plurality of pieces of prediction data B1, B2, B3, and B4. That is, the weight applied to the feature of the battery data in training of the plurality of machine learning models 211, 212, 213, and 214 is different from the weight applied to each of the plurality of pieces of prediction data B1, B2, B3, and B4. For example, to determine a weight to be applied to the prediction data B1, the controller 220 may consider the weight applied based on the feature of the battery data A in training of the DNN model included in the machine learning model 211 generating the prediction data B1.

Likewise, the controller 220 may consider the weight applied based on the feature of the battery data A in training of the DNN model included in the machine learning model 212 generating the prediction data B2 to determine the weight to be applied to the prediction data B2, consider the weight applied based on the feature of the battery data A in training of the DNN model included in the machine learning model 213 generating the prediction data B3, and consider the weight applied based on the feature of the battery data A in training of the DNN model included in the machine learning model 214.

According to an embodiment, the weights respectively applied to the plurality of pieces of prediction data B1, B2, B3, and B4 may be proportional to the weight applied to the feature of the battery data A in training of each of the machine learning models 211, 212, 213, and 214. For example, when features related to the separator type and the assembly process among the features of the battery data A are considered in a process of training the machine learning model 211 generating the prediction data B1, the controller 220 may apply the weight corresponding to the separator type and the weight corresponding to the assembly process type to the prediction data B1, in which the weight corresponding to the separator type and the weight corresponding to the assembly process may be proportional to the weight applied to the feature of the battery data, related to the separator type, and the weight applied to the feature of the battery data, related to the assembly process, in the process of training the machine learning model 211. Herein, the weight x1 may be a sum of the weight corresponding to the separator type and the weight corresponding to the assembly process type, but is not limited to this example.

That is, the controller 220 may calculate the final gas generation amount prediction data C by applying a fuzzy algorithm capable of reflecting importance and a feature of a specific variable, instead of simply calculating a mean of the plurality of pieces of prediction data B1, B2, B3, and B4 by respectively applying the weights x1, x2, x3, and x4 to the plurality of pieces of prediction data B1, B2, B3, and B4.

For example, the controller 220 may input the plurality of pieces of prediction data B1, B2, B3, and B4 having the weights x1, x2, x3, and x4 applied thereto to an ensemble learning model, thereby generating the gas generation amount prediction data C in a probability distribution form. Herein, the ensemble learning model may be a machine learning scheme having the better performance than one learning model by combining two or more learning models. The ensemble learning model may calculate a weighted sum by applying a weight to output data of each model, instead of a mean of the output data of each model, when each model has different reliability. Herein, the weighted sum may be defined as a mean obtained by reflecting a weight value corresponding to an importance or influence of a data value when a mean of data is obtained.

The controller 220 may calculate a mean of the gas generation amount prediction data C in the form of a probability distribution. More specifically, the controller 220 may calculate a 95 % prediction interval of the mean of the gas generation amount prediction data C in the form of a probability distribution. For example, the controller 220 may calculate the mean of the gas generation amount prediction data C in a probability distribution form and a standard deviation and then calculate 'mean ± standard deviation * 1.96' as the 95 % prediction interval of the mean of the gas generation amount prediction data C.

The controller 220 may compare the prediction interval of the gas generation amount prediction data C in a probability distribution form with a pre-stored battery gas generation amount measurement value to determine accuracy of the plurality of machine learning models 211, 212, 213, and 214.

As described above, the battery state prediction apparatus and an operating method thereof according to an embodiment disclosed herein may obtain gas generation amount prediction data in a probability distribution form by using a plurality of artificial intelligence models.

The battery state prediction apparatus may input a small number of pieces of input data to a plurality of artificial intelligence models, thereby calculating final prediction data with high accuracy and reducing time and cost required for collection and management of data.

Moreover, the battery state prediction apparatus may set a weight according to features of data to reflect unique features of actual battery data and features of a use environment of the actual battery.

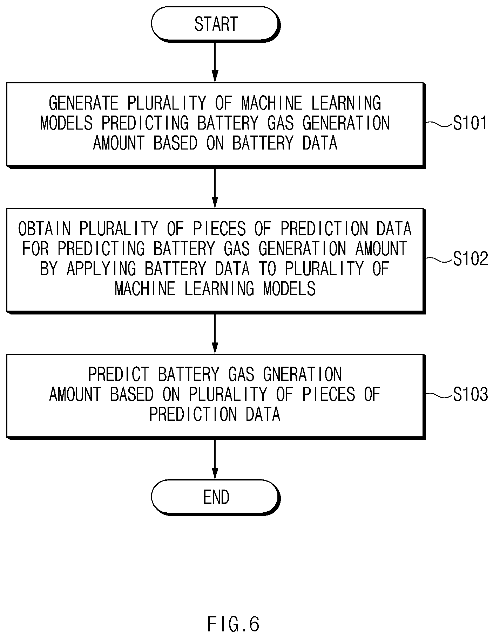

FIG. 6 is a flowchart of an operating method of a battery state prediction apparatus according to an embodiment disclosed herein.

The battery state prediction apparatus 200 may be substantially the same as the battery state prediction apparatus 200 described with reference to FIGS. 1 to 5, and thus will be briefly described to avoid redundant description.

Referring to FIG. 6, the operating method of the battery state prediction apparatus may include operation S101 of generating a plurality of machine learning models predicting a battery gas generation amount based on battery data, operation S102 of obtaining a plurality of pieces of prediction data for predicting the battery gas generation amount by applying the battery data to the plurality of machine learning models, and operation S103 of predicting the battery gas generation amount based on the plurality of pieces of prediction data.

Hereinbelow, operations S101 through S103 will be described in detail.

In operation S101, the generation unit 210 may collect the battery data A. For example, the battery data A may be defined as a value that records a battery state change from discharge states of the plurality of battery cells 110, 120, 130, and 140 to full charge states thereof or from the full charge states to the discharge states. For example, the battery data A may include voltage, current, temperature, SOC, and SOH of the battery, measured accumulatively. Herein, the SOH may include capacity degradation and resistance degradation of the battery. In addition, the battery data A may further include at least one of data related to which type the separator type of the battery is, through which assembling process the battery is assembled, and/or which electrode type the battery has.

In operation S101, the generation unit 210 may generate the plurality of machine learning models 211, 212, 213, and 214 by extracting at least a part of the battery data A as the training data set. In operation S101, for example, the generation unit 210 may generate the plurality of machine learning models 211, 212, 213, and 214 by extracting 80 % of the battery data A as the training data set.

In operation S101, the generation unit 210 may generate the plurality of machine learning models 211, 212, 213, and 214 trained based on at least one of features of the battery data A. For example, when the separator type and the electrode type among the features of the battery data A are considered, the generation unit 210 may extract the battery data A including the separator type and the electrode type of the battery, except for the voltage, the current, the temperature, the SOC, and the SOH of the battery, as the training data set of the battery A, thereby generating the plurality of machine learning models 211, 212, 213, and 214.

Herein, the generation unit 210 may train the plurality of machine learning models 211, 212, 213, and 214 with the battery data A by applying various weights to the features of the battery data A including the separator type, the assembly process, and the electrode type of the battery among various features included in the battery data A.

For example, the generation unit 210 may use a regularization scheme for resolving overfitting of the plurality of machine learning models 211, 212, 213, and 214 by minimizing intervention of relatively unimportant data among the separator type, the assembly process, and the electrode type of the battery based on a drop-out scheme (a), thereby generating the plurality of machine learning models 211, 212, 213, and 214. That is, the generation unit 210 may generate the plurality of machine learning models 211, 212, 213, and 214 by training the machine learning models 211, 212, 213, and 214 with the battery data A from which connection of a node related to a feature, intervention of which is unwanted or is to be minimized, among the separator type, the assembly process, and the electrode type of the battery, is removed.

In another example, the generation unit 210 may generate the plurality of machine learning models 211, 212, 213, and 214 trained with the battery data A by (b) fixing weights applied to the features of the battery data A including the separator type, the assembly process, and the electrode type of the battery among various features included in the battery data A. For example, to generate a machine learning model affected much by the separator type of the battery, the generation unit 210 may train the machine learning model with the battery data A by applying a high weight (e.g., *a) to the separator type among the features of the battery data A. To generate a machine learning model affected less by the electrode type of the battery, the generation unit 210 may train the machine learning model with the battery data A by applying a low weight (e.g., *b) to the electrode type among the features of the battery data A.

In another example, the generation unit 210 may generate the plurality of machine learning models 211, 212, 213, and 214 trained with the battery data A by (c) applying a bias (e.g., +a' or +b') to a node connected to the battery data A including the separator type, the assembly process, and the electrode type of the battery among various features included in the battery data A.

In addition, the generation unit 210 may generate the plurality of machine learning models 211, 212, 213, and 214 trained with the battery data A based on weight regulations including L1 regulation Lasso and L2 regulation Ridge, and an embodiment disclosed herein is not limited to this example.

In operation S101, according to an embodiment, the plurality of machine learning models 211, 212, 213, and 214 may include a plurality of deep neural network (DNN) models. The DNN model is an artificial neural network technique including multiple hidden layers between an input layer and an output layer. The DNN model may learn various complex nonlinear relationships by including the multiple hidden layers. In operation S101, the generation unit 210 may generate the plurality of machine learning models 211, 212, 213, and 214 capable of predicting a battery gas generation amount by using at least a part of the battery data A as the training data set.

In operation S101, the generation unit 210 may min-max scale at least a part of the battery data A, Herein, min-max scaling is a method of adjusting a range of all variables because when a size or unit of a numeric variable differs from variable to variable, an impact thereof on a dependent variable is not properly reflected. The generation unit 210 may convert at least a part of the battery data A into a value between 0 and 1 by min-max scaling the at least a part of the battery data A.

In operation S101, the generation unit 210 may determine accuracy of the plurality of machine learning models 211, 212, 213, and 214 by K-fold cross validation with respect to the plurality of machine learning models 211, 212, 213, and 214. K-fold cross validation is a method of dividing a pre-processed data set into a training data set and a test set and dividing the training data set into 'K' folds to use one fold for validation and (K-1) folds for model training, thereby using every data for training and validation processes. For example, the generation unit 210 may determine accuracy of the plurality of machine learning models 211, 212, 213, and 214 by 5-fold cross validation with respect to the plurality of machine learning models 211, 212, 213, and 214.

In operation S101, for example, the generation unit 210 may evaluate performance of the plurality of machine learning models 211, 212, 213, and 214 based on a mean absolute error (MAE) that is a mean of an absolute value into which an error between an actual value and a prediction value is converted.

In operation S102, the controller 220 may input at least a part of the battery data A including voltage, current, temperature, SOC, and SOH changes of the plurality of battery cells 110, 120, 130, and 140, and the separator type and the electrode type of the battery, as a test data set, into the plurality of machine learning models 211, 212, 213, and 214.

In operation S102, for example, after the generation unit 210 generates the plurality of machine learning models 211, 212, 213, and 214 by extracting 80 % of the battery data A as a training data set, the controller 220 may extract the other 20 % as a test data set and input the same to the plurality of machine learning models 211, 212, 213, and 214.

In operation S102, the controller 220 may apply at least a part of the battery data A to the plurality of machine learning models 211, 212, 213, and 214 to obtain a plurality of pieces of prediction data B1, B2, B3, and B4 for predicting battery gas generation amounts of the battery respectively from the plurality of machine learning models 211, 212, 213, and 214.

In operation S102, that is, the controller 220 may obtain a plurality of pieces of output data Output by respectively inputting at least a part of the battery data A that is single input data Input to individual machine learning models. The controller 220 may generate the gas generation amount prediction data C for predicting the gas generation amount of the battery, based on the plurality of pieces of prediction data B1, B2, B3, and B4.

In operation S102, the controller 220 may apply the at least a part of the battery data A to the plurality of DNN models included in the plurality of machine learning models 211, 212, 213, and 214.

In operation S103, the controller 220 may predict the state of the battery, based on the plurality of pieces of prediction data B1, B2, B3, and B4.

In operation S103, according to an embodiment, the controller 220 may apply weights x1, x2, x3, and x4 respectively to the plurality pieces of prediction data B1, B2, B3, and B4 generated by the plurality of machine learning models 211, 212, 213, and 214 based on the obtained feature of the battery data A. Herein, the weights x1, x2, x3, and x4 respectively applied to the plurality of pieces of prediction data B1 B2, B3, and B4 may be related to the weight applied to the feature of the battery data A in training of each of the plurality of machine learning models 211, 212, 213, and 214.

According to an embodiment, the controller 220 may apply weights to the plurality of pieces of prediction data B1, B2, B3, and B4 according to the weight applied based on the feature of the battery data A in a process of training an DNN model used in generation of the plurality of pieces of prediction data B1, B2, B3, and B4. That is, the weight applied to the feature of the battery data in training of the plurality of machine learning models 211, 212, 213, and 214 is different from the weight applied to each of the plurality of pieces of prediction data B1, B2, B3, and B4. For example, to determine a weight to be applied to the prediction data B1, the controller 220 may consider the weight applied based on the feature of the battery data A in training of the DNN model included in the machine learning model 211 generating the prediction data B1.

Likewise, the controller 220 may consider the weight applied based on the feature of the battery data A in training of the DNN model included in the machine learning model 212 generating the prediction data B2 to determine the weight to be applied to the prediction data B2, consider the weight applied based on the feature of the battery data A in training of the DNN model included in the machine learning model 213 generating the prediction data B3, and consider the weight applied based on the feature of the battery data A in training of the DNN model included in the machine learning model 214.

In operation S103, for example, the controller 220 may input the plurality of pieces of prediction data B1, B2, B3, and B4 having the weights x1, x2, x3, and x4 applied thereto to an ensemble learning model, thereby generating the gas generation amount prediction data C in a probability distribution form. Herein, the ensemble learning model may be a machine learning scheme having the better performance than one learning model by combining two or more learning models.

In operation S103, the controller 220 may calculate a mean of the gas generation amount prediction data C in the form of a probability distribution. In operation S103, more specifically, the controller 220 may calculate a 95 % prediction interval of the mean of the gas generation amount prediction data C in the form of a probability distribution. In operation S103, for example, the controller 220 may calculate the mean of the gas generation amount prediction data C in a probability distribution form and a standard deviation and then calculate 'mean ± standard deviation * 1.96' as the 95 % prediction interval of the mean of the gas generation amount prediction data C.

In operation S103, the controller 220 may compare the prediction interval of the gas generation amount prediction data C in a probability distribution form with a pre-stored battery gas generation amount measurement value to determine accuracy of the plurality of machine learning models 211, 212, 213, and 214.

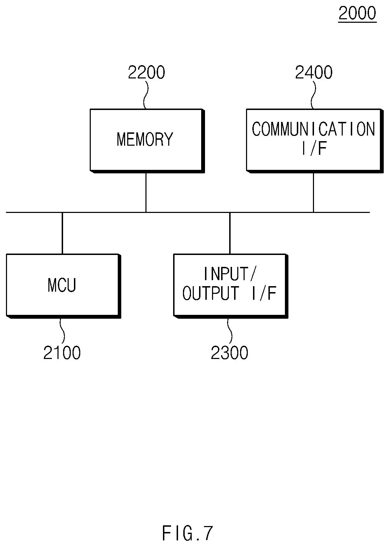

Referring to FIG. 7, a computing system 2000 according to an embodiment disclosed herein may include an MCU 2100, a memory 2200, an input/output I/F 2300, and a communication I/F 2400.

The MCU 2100 may be a processor that executes various programs (e.g., a battery gas generation amount program, etc.) stored in the memory 2200, processes various data through these programs, and perform the above-described functions of the battery management apparatus 200 shown in FIG. 1.

The memory 2200 may store various programs regarding operations of the battery state prediction apparatus 200. Moreover, the memory 2200 may store operation data of the battery state prediction apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

## Claims

1. A battery state prediction apparatus comprising:
a generation unit configured to generate a plurality of machine learning models trained based on battery data and features included in the battery data to predict a gas generation amount of a battery; and
a controller configured to obtain a plurality of pieces of prediction data for predicting the gas generation amount of the battery by applying the battery data to the plurality of machine learning models and predict the gas generation amount of the battery based on the plurality of pieces of prediction data.

2. The battery state prediction apparatus of claim 1, wherein the plurality of machine learning models comprise a plurality of deep neural network (DNN) models, and
the controller is further configured to obtain the plurality of pieces of prediction data by applying the battery data to the plurality of DNN models.

3. The battery state prediction apparatus of claim 2, wherein the battery data comprises a temperature, a state of charge (SOC), and a state of health (SOH) of the battery, which are accumulatively measured, and
the features of the battery data comprise at least one or more of an electrode type, an assembly process, and a separator type of the battery.

4. The battery state prediction apparatus of claim 2, wherein the controller is further configured to apply a weight to each of the plurality of pieces of prediction data based on a weight applied based on the features of the battery data in a process of training the DNN model that generates each of the plurality of pieces of prediction data, and input the plurality of pieces of prediction data to which the weight is applied to an ensemble learning model to generate prediction data for the gas generation amount in a probability distribution form.

5. The battery state prediction apparatus of claim 4, wherein the controller is further configured to calculate a mean of the prediction data for the gas generation amount in the probability distribution form, and determine accuracy of the plurality of machine learning models by comparing the mean with a pre-stored gas generation amount measurement value of the battery.

6. An operating method of a battery state prediction apparatus, the operating method comprising:
generating a plurality of machine learning models trained based on battery data and features included in the battery data to predict a gas generation amount of a battery;
obtaining a plurality of pieces of prediction data for predicting the gas generation amount of the battery by applying the battery data to the plurality of machine learning models; and
predicting the gas generation amount of the battery based on the plurality of pieces of prediction data.

7. The operating method of claim 6, wherein the plurality of machine learning models comprise a plurality of deep neural network (DNN) models, and
the obtaining of the plurality of pieces of prediction data for predicting the gas generation amount of the battery by applying the battery data to the plurality of machine learning models comprises obtaining the plurality of pieces of prediction data by applying the battery data to the plurality of DNN models.

8. The operating method of claim 6, wherein the generating of the plurality of machine learning models that predict the gas generation amount of the battery based on the battery data comprises generating the plurality of machine learning models based on the battery data comprising a temperature, a state of charge (SOC), and a state of health (SOH) of the battery, which are accumulatively measured, and
the features of the battery data comprise at least one or more of an electrode type, an assembly process, and a separator type of the battery.

9. The operating method of claim 6, wherein the predicting of the gas generation amount of the battery based on the plurality of pieces of prediction data comprises:
applying a weight to each of the plurality of pieces of prediction data based on a weight applied based on the features of the battery data in a process of training the DNN model that generates each of the plurality of pieces of prediction data; and
inputting the plurality of pieces of prediction data to which the weight is applied to an ensemble learning model to generate prediction data for the gas generation amount in a probability distribution form.

10. The operating method of claim 6, wherein the predicting of the gas generation amount of the battery based on the plurality of pieces of prediction data comprises:
calculating a mean of the prediction data for the gas generation amount in the probability distribution form; and
determining accuracy of the plurality of machine learning models by comparing the mean with a pre-stored gas generation amount measurement value of the battery.
